# EUROPÄISCHE PATENTSCHRIFT

(11) **EP 1 364 394 B1**
(45) Veröffentlichungstag und Bekanntmachung des Hinweises auf die Patenterteilung: **04.04.2007**
(21) Anmeldenummer: 02706639.8
(22) Anmeldetag: 29.01.2002
(51) Int. Cl.: H01L 21/285, B81C 1/00, H01L 21/321, H01L 21/336, H01L 21/28, H01L 21/316, H01L 21/335, H01L 21/74, H01L 21/768

(54) **VERFAHREN ZUR HERSTELLUNG VON STRUKTUREN IM NANOMETERBEREICH**
METHOD FOR PRODUCING STRUCTURES ON THE NANOMETRIC SCALE
PROCEDE DE REALISATION DE STRUCTURES A L'ECHELLE NANOMETRIQUE

(30) Priorität: 02.03.2001 DE 10110234
(43) Veröffentlichungstag der Anmeldung: 26.11.2003
(73) Patentinhaber: Forschungszentrum Jülich GmbH, 52425 Jülich (DE)
(72) Erfinder: KLUTH, Patrick, Ainslie ACT 2602 (AU); ZHAO, Quing-Tai, 524 28 Jülich (DE); MANTL, Siegfried, 52428 Jülich (DE)
(86) Internationale Anmeldenummer: PCT/DE2002/000301
(87) Internationale Veröffentlichungsnummer: WO 2002/071460

(56) Entgegenhaltungen:
- DE-A- 19 853 023
- P.KLUTH ET. AL.: "Fabrication of epitaxial CoSi2 Nanowires" APPLIED PHYSICS LETTERS, Bd. 79, Nr. 6, 6. August 2001 (2001-08-06), Seiten 824-826, XP002225698
- ZHAO Q T ET AL: "Properties of ion implanted epitaxial CoSi2/Si(100) after rapid thermal oxidation" NUCLEAR INSTRUMENTS & METHODS IN PHYSICS RESEARCH, SECTION - B: BEAM INTERACTIONS WITH MATERIALS AND ATOMS, NORTH-HOLLAND PUBLISHING COMPANY. AMSTERDAM, NL, Bd. 164-165, April 2000 (2000-04), Seiten 1004-1009, XP004195289 ISSN: 0168-583X
- Q.T.ZHAO: "Nanometer patterning of epitaxial CoSi2/Si(100)" APPLIED PHYSICS LETTERS, Bd. 74, Nr. 3, 18. Januar 1999 (1999-01-18), Seiten 454-456, XP002225699
- S. MANTL: "Patterning method for Silicides based on local Oxidation" APPLIED PHYSICS LETTERS, Bd. 67, Nr. 23, 4. Dezember 1995 (1995-12-04), Seiten 3459-3461, XP002225700
- PEPIN A ET AL: "Evidence of stress dependence in the diffusion of point defects in GaAs/GaAlAs heterostructures" SEMICONDUCTING AND SEMI-INSULATING MATERIALS CONFERENCE, 1996. IEEE TOULOUSE, FRANCE 29 APRIL-3 MAY 1996, NEW YORK, NY, USA,IEEE, US, 29. April 1996 (1996-04-29), Seiten 263-266, XP010213073 ISBN: 0-7803-3179-6
- PATENT ABSTRACTS OF JAPAN vol. 1995, no. 09, 31. Oktober 1995 (1995-10-31) & JP 07 161963 A (MATSUSHITA ELECTRIC IND CO LTD), 23. Juni 1995 (1995-06-23)

## Beschreibung

Die Erfindung betrifft ein Verfahren zur Herstellung von Strukturen im Nanometerbereich und deren Nutzen für elektronische Bauelemente.

S.A. Rishton et al. ("New Complimentary Metal-Oxide Semiconductor Technology with Self-Aligned Schottky Source & Drain and Low-Resistance T Gates", J. Vac. Sci. Technol. B 15(6), Nov/Dec 1997) offenbart eine Schichtstruktur und ein elektronisches Bauelement mit einer Breite von 10 - 500 nm.

D. Hisamoto et al. ("Finfet-A Self-Aligned Double-Gate MOSFET Scalable to 20 nm", IEEE Transactions on Electron Devices, IEEE Vol. 47 (12) Dec 2000) offenbart einen Doppel-Gate-MOSFET.

Zur Herstellung von Strukturen im Nanometerbereich wird im Stand der Technik unter anderem die optische Lithographie eingesetzt. Dabei wird mit Hilfe der Maskentechnik beleuchtungsunterstützt die gewünschte Struktur auf einen photoempfindlichen Lack übertragen, welcher dann als Maske für die Herstellung der eigentlichen Struktur dient. Diese konventionelle optische Lithographie erlaubt eine Auflösung von bis zu 130 nm. Verfahren mit noch besserer Auflösung, wie die Röntgenstrahllithographie, die Elektronenstrahllithographie oder die deep-UV-Lithographie sind bisher nur im Labormaßstab möglich und erfordern einen hohen technischen Aufwand mit hohen Kosten (R. Kassing, R. Käsmeier, I. W. Rangelow, Lithographie der nächsten Generation. Physikalische Blätter, Vol. 56, Nr. 2, 31ff).

In der Mikroelektronik stellt die Erzeugung von Strukturen im Nanometerbereich, wie z. B. dünnen Drähten aus reinen Metallen oder Siliziden, eine große Herausforderung dar. Solche Strukturen können als Kontaktmaterialien und Verbindungsleitungen für elektronische Bauelemente dienen. Insbesondere die Strukturierung von Kobaltdisilizid, eines der wichtigsten Kontaktmaterialien der Chiptechnologie, gestaltet sich schwierig, da hierfür keine standardisierten Ätzprozesse existieren.

Neben der Funktion als Kontakt- und Verbindungsmaterialien können solche Strukturen auch als Maske, z. B. in Ätzverfahren zur Erzeugung dreidimensionaler Strukturen, in einem darunter liegenden Substrat oder weiteren zu strukturierenden Schichten verwendet werden.
In der Siliziumtechnologie stellen solche Strukturen eine wesentliche Grundlage für die Herstellung vertikaler Doppel-Gate MOSFETs dar. Solche MOSFETs sind aussichtsreiche Bauelemente zur Miniaturisierung von Transistoren und für die Überwindung der damit verbundenen technischen Probleme (L. Risch, 2000. The end of the roadmap - new landscape beyond. The 13^{th} Japan-Germany Forum on Information Technology, Proceedings-Band, 11(2)-1).

Nachteilig ist die Übertragung von im Photolack erzeugten Strukturen auf die darunter liegenden Schichten abhängig von den Eigenschaften der zu strukturierenden Materialien. Daher möchte man Verfahren zur Strukturierung entwickeln, die auf selbstjustierenden Prozessen beruhen.

Aus DE 195 03 641 A1 ist ein Verfahren zur Strukturierung von Silizidschichten bekannt, welches auf der lokalen Oxidation von Siliziden beruht. Hierbei wird durch einen selbstjustierenden Prozeß z. B. eine Kobaltdisilizidschicht in zwei Bereiche aufgetrennt.

Aus DE 198 53 023 A1 ist ein Verfahren zur Herstellung einer eine Sub-Mikrometerstruktur aufweisenden Schicht auf einem Substrat bekannt. Dabei wird auf dem Substrat eine Schicht gebildet. Es werden Mittel zur Ausbildung elastischer Spannungen an wenigstens einer vorgegebenen Position dieser Schicht gebildet und sodann die Schicht selbstjustierend an dieser Position durch spannungsabhängige Diffusion getrennt. Die Diffusion kann im Rahmen einer Festkörperreaktion erfolgen. Die Diffusion betrifft dabei Bereiche aus einer zu strukturierenden Schicht. Die Trennung der zu strukturierenden Schicht erfolgt in einem selbstjustierenden Prozeß entlang einer Maskenkante.

Nachteilig kann mit den im Stand der Technik bekannten Verfahren nur eine Trennung von Schichten in unterschiedliche Bereiche erfolgen. Darüber hinausgehende, z. B. erhabene Strukturen mit Breiten von kleiner als 130 nm lassen sich nicht erzeugen.

Aufgabe der Erfindung ist es daher, ein Verfahren anzugeben, daß die im Stand der Technik auftretenden Nachteile nicht aufweist. Aufgabe der Erfindung ist weiterhin, elektronische Bauteile mit entsprechenden Strukturen bereitzustellen.

Die Aufgabe wird gelöst durch ein Verfahren gemäß Anspruch 1, eine Schichtstruktur gemäß Anspruch 21 sowie ein elektronisches Bauelement gemäß Anspruch 23. Vorteilhafte Ausgestaltungen der Erfindung gehen aus den darauf rückbezogenen Ansprüchen hervor.

Gemäß kennzeichnendem Teil von Anspruch 1 ist das Verfahren durch folgende Schritte gekennzeichnet:
- zur Festlegung einer ersten seitlichen Begrenzung der zu bildenden Struktur werden entweder maskierte Bereiche der zu strukturierenden Schicht von nicht maskierten Bereichen zur Bildung einer ersten Struktur voneinander getrennt oder nicht maskierte Bereiche durch Ätzung entfernt,
- eine elastische Spannung wird lateral zur Oberfläche der zu strukturierenden Schicht verschoben,
- Bereiche der zu strukturierenden Schicht werden durch eine spannungsabhängige Diffusion zur Festlegung einer zweiten seitlichen Begrenzung der zu bildenden Struktur voneinander getrennt.

Es wird zunächst eine zu strukturierende Schicht auf einem Substrat gebildet. Dann werden auf diese eine oder mehrere Schichten aufgebracht, welche zu einer Maske strukturiert werden. In der Maskenstruktur entstehen auf Grund des Kristallaufbaus der aufgebrachten Schichten intrinsische Spannungen. Mindestens eine Schicht in der Maskenstruktur erzeugt daher an ihren Kanten eine elastische Spannung, welche auf die darunter liegenden, zu strukturierenden Schichten eine mechanische Kraft ausübt.

Die Herstellung der ersten Struktur erfolgt entlang der Maskenkante. Dabei werden die nicht maskierten Bereiche der zu strukturierenden Schicht von den von der Maske verdeckten Teilen getrennt. Alternativ ist es möglich, die nicht maskierten Bereiche der zu strukturierenden Schicht von den maskierten Bereichen durch Ätzung zu entfernen. Dies dient der Festlegung einer ersten seitlichen Begrenzung der zu bildenden Struktur.

Anschließend wird die elastische Spannung lateral und über eine kontrollierte Länge über einen zu strukturierenden Bereich der darunter liegenden, zu strukturierenden Schicht verschoben. Dies wird durch eine Modifikation der Maskenstruktur, z. B. durch Entfernen von Teilen der Maskenstruktur erreicht. Die elastische Spannung wird an eine Position verschoben, an der innerhalb der zu strukturierenden Schicht eine Auftrennung erfolgen soll. Lateral bezieht sich somit auf eine Orientierung, die horizontal zur Oberfläche der zu strukturierenden Schicht gerichtet ist.

In einem abschließenden Verfahrensschritt erfolgt eine spannungsabhängige Diffusion, durch den Bereiche der zu strukturierenden Schicht getrennt werden. Hierdurch wird eine zweite seitliche Begrenzung der zu bildenden Struktur festgelegt. Die Breite der Struktur ist nicht durch die Abmessungen der Maske, sondern durch Verschieben der elastischen Spannung über eine kontrollierte Länge und abschließender spannungsabhängiger Diffusion bestimmt.

Diese Verfahrensschritte können sich anschließend zur Bildung weiterer Strukturen wiederholen.

Das Verfahren ist geeignet zur Herstellung von Strukturen mit einer Breite in einer Größenordnung von 10 nm bis zu 500 nm.

Das Verfahren ist besonders geeignet, linienförmige Strukturen, z. B. Drähte, herzustellen, die eine Breite in einer Größenordnung von 10 nm bis zu 500 nm aufweisen.

Vorteilhaft umfaßt die laterale Verschiebung der elastischen Spannung einen Ätzprozeß.

Es kann z. B. ein naßchemischer Ätzprozeß angewendet werden. Hierdurch können auf besonders einfache Weise gezielt Teile der Maskenstruktur auf Grund ihrer Materialeigenschaften, z. B. durch Säuren, entfernt werden. Die elastische Spannung wird dabei entlang der sich durch den Ätzprozeß verändernden Maskenkanten in Ätzrichtung verschoben. Dabei kann entweder die spannungserzeugende Schicht selbst oder auch eine weitere Zwischenschicht, die die elastische Spannung auf die darunter liegende, zu strukturierende Schicht überträgt, zurückgeätzt werden.

Als Trockenchemischer Prozeß ist das reaktive Ionenätzen anwendbar. Dieses Verfahren weist den Vorteil auf, daß Ätzprozesse reproduzierbar und anisotrop erfolgen.

In einer vorteilhaften Ausgestaltung der Erfindung umfaßt die spannungsabhängige Diffusion Tempern, eine lokale Oxidation und/oder eine spezifische Legierungsbildung.
Die spannungsabhängige Diffusion kann durch Tempern bei geeigneten Parametern für die verwendeten Materialien ausgelöst werden. Die Temperatur und Zeitdauer sollte dafür eine geeignete Diffusionslänge für das Material der zu strukturierenden Schicht hervorrufen.
Im Falle von Siliziden bietet sich eine lokale Oxidation in sauerstoffhaltiger Atmosphäre, z. B. bei 800-1000 °C an. Durch Diffusion werden Bereiche in der zu strukturierenden Schicht voneinander getrennt.
Die Bildung spezifischer Silizide durch Aufbringen von Metallen, insbesondere Cobalt, Titan und Nickel, auf ein Siliziumsubstrat kann bei geeigneten Temperaturen ebenfalls eine Trennung der zu strukturierenden Schicht durch spezifische Legierungsbildung hervorrufen. Es entstehen entsprechende metallische Mono- oder Di-Silizide.

In besonders vorteilhafter Weise umfaßt die Bildung der ersten Struktur in der zu strukturierenden Schicht eine spannungsabhängige Diffusion.
Auf diese Weise erreicht man, daß beide Strukturierungen entlang der Kante einer Maskenstruktur selbstjustierend sind.

Die zu strukturierende Schicht enthält vorteilhaft mindestens ein Metall, und zwar insbesondere Co, Ti, Ni, Pd, Pt, W, Ta oder Nb bzw. deren Silizide.
Diese Metalle stellen auf Grund ihrer guten elektrischen Leitfähigkeit geeignete Materialien für Kontakte oder Verbindungsleitungen von elektronischen Bauteilen dar, wobei die entsprechenden Silizide in der Siliziumtechnologie wegen ihrer hohen Kompatibilität zu Silizium besonders vorteilhaft sind.

Als Material für die zu strukturierende Schicht ist insbesondere CoSi₂ geeignet.
CoSi₂ ist für die Halbleitertechnologie sehr bedeutsam. Es kann zudem in einer Weise strukturiert werden, daß Strukturen mit einer Breite von 50 Nanometer und weniger hergestellt werden.

Als Materialien zur Bildung der Maskenstruktur kann insbesondere SiO₂ und Si₃N₄ angewendet werden.
In vorteilhafter Weise lassen sich sowohl SiO₂ als auch Si₃N₄ durch Ätzprozesse leicht strukturieren, wodurch die elastische Spannung verschoben wird. Die Verbindungen können in der Maske beispielsweise als Schichten vorliegen. Si₃N₄ ist besonders vorteilhaft, da es auf Grund seiner intrinsischen Eigenschaften die gewünschten elastischen Spannungen erzeugt.

Besonders vorteilhaft umfaßt die Maskenstruktur eine SiO₂-Si₃N₄-Schichtenfolge oder eine SiO₂-Si₃N₄-SiO₂-Schichtenfolge.
In beiden genannten Schichtenfolgen dient dabei die jeweils letztgenannte Schicht, also die Si₃N₄-Schicht bzw. eine SiO₂-Schicht unter anderem als Deckschicht, die eine Strukturierung der darunter liegenden Maskenschicht in vertikaler Richtung verhindert. Die Si₃N₄-Schicht ist dabei jeweils die spannungserzeugende Schicht.

In einer weiteren Ausgestaltung der Erfindung ist eine weitere lokal angebrachte Schutzschicht auf der zu strukturierenden Schicht aufgebracht.
Während des ersten und/oder zweiten Strukturierungsprozesses können Bereiche der zu strukturierenden Schicht mit einer weiteren nicht spannungserzeugenden Schicht abgedeckt werden, wodurch diese Bereiche erhalten bleiben.

Die Schutzschicht kann weiterhin auch Bereiche der Maskenstruktur abdecken.
In diesen Bereichen wird somit verhindert, daß die elastische Spannung verschoben wird.
Dabei kann insbesondere Photolack als Schutzschicht bei Prozessen ohne Temperung verwendet werden. Photolack ist preiswert und in einfacher Weise auf die zu strukturierende Schicht bzw. auf die Maske auftragbar.
Für Prozesse, die eine Temperung umfassen, ist SiO₂ als Schutzschicht geeignet, da es nur kleine elastische Spannungen erzeugt.
Auf diese Weise werden Drähte mit Kontaktflächen erzeugt.

Die Maskenstruktur kann anschließend.entfernt werden. Die freigelegte, strukturierte Schicht kann als Maske für eine Strukturierung des darunter liegenden Substrates oder weiterer Schichten verwendet werden.

Durch das erfindungsgemäße Verfahren erzeugte Strukturen können somit z. B. im Bereich der Nanoelektronik zur Bildung von Bauelementen und Bauelementverbindungen sowie zur Herstellung von Masken für die Nanostrukturierung Einsatz finden.
Ein elektronisches Bauelement, welches eine durch das erfindungsgemäße Verfahren gebildete Struktur, z. B. in Form von Leiterbahnen, dünnen Drähten oder Kontakten aufweist, weist damit alle Vorteile der gebildeten Strukturen oder Drähte auf.

Für ein Silizium Doppel-Gate MOSFET-Bauelement können die hergestellten Strukturen sowohl als Ätzmaske, als auch als Source- bzw. Drainkontakt verwendet werden.

Im Ergebnis erlaubt das erfindungsgemäße Verfahren die Erzeugung extrem dünner Drähte mit Breiten von 50 nm und weniger ohne aufwendige lithographische Prozesse. Die Breite ist im wesentlichen abhängig von der kontrollierten räumlichen Verschiebung der elastischen Spannung entlang der Oberfläche der zu strukturierenden Schicht. Weiterhin ist die Breite von der Schichtdicke und dem Material der zu strukturierenden Schicht sowie den Prozeßparametern für den oder die selbstjustierenden Prozesse, wie Maskenaufbau und z. B. thermische Behandlung, abhängig. Die Kombination mit lokal aufgebrachten Schutzschichten erlaubt die Verbindung der Drähte mit größeren Strukturen z. B. unter Verwendung der optischen Lithographie.

Die Vorteile des Verfahrens liegen in der Möglichkeit der Erzeugung dünner Drähte mit Dimensionen jenseits der Auflösungsgrenze der optischen Lithographie, wie sie industriell angewandt wird. Zudem beinhaltet das Verfahren technologisch einfache Prozesse und daher sehr gute Reproduzierbarkeit. Darüber hinaus bietet das Verfahren bezüglich der zu erzeugenden Strukturen sowie durch weitreichende Kombinationsmöglichkeiten verschiedener Schutzschichten, Masken und Strukturierungsprozesse ein hohes Maß an Flexibilität.

Die Erfindung wird im weiteren anhand der beigefügten Figuren und dreier Ausführungsbeispiele näher erläutert.

Figur 1 zeigt einen Querschnitt durch ein Substrat 1, auf dessen Oberfläche eine zu strukturierende Schicht 2 und eine Maskenstruktur 3 aufgebracht wurden. Die Maskenstruktur wurde mit herkömmlicher Lithographie strukturiert.

Figur 2 zeigt die zu Figur 1 gehörige Aufsicht mit zwei lokal aufgebrachten Schutzschichten 4.

Figur 3 zeigt einen Querschnitt der Anordnung aus den nicht von den Schutzschichten 4 bedeckten Bereichen, nachdem die zu strukturierende Schicht 2 zur Bildung einer ersten Struktur bis auf die von der Maskenstruktur 3 und den Schutzschichten 4 geschützten Bereiche entfernt wurde.

Figur 4 zeigt einen Querschnitt der Anordnung nach einem selektiven Ätzprozeß, durch den Teile der Schicht 3b aus der Maskenstruktur 3 entfernt wurden.

Figur 5 zeigt einen Querschnitt der Anordnung nach Bildung einer zweiten Struktur durch eine spannungsabhängige Diffusion. Die Breite des Drahtes 2b wird durch beide Strukturierungen festgelegt. Neben Draht 2b entsteht eine Lücke 1a.

Figur 6 zeigt die zum Querschnitt aus Figur 5 gehörige Aufsicht nach Entfernen der Maskenschichten 3a-c. Durch die aufgebrachten Schutzschichten 4 ist der entstandene Draht 2b mit zwei Teilen der zu strukturierenden Schicht 2 an diesen Stellen verbunden geblieben.

Figur 7 zeigt einen Querschnitt durch ein Substrat 11 eines zweiten Ausführungsbeispiels. Auf dessen Oberfläche ist die zu strukturierende Schicht 12 und die Maskenstruktur 13 aufgebracht. Die Maskenstruktur wurde mit herkömmlicher Lithographie strukturiert.

Figur 8 zeigt einen Querschnitt der Anordnung, nachdem maskierte Bereiche 12a der zu strukturierenden Schicht von nicht maskierten Bereichen 12b zur Bildung einer ersten Struktur durch spannungsabhängige Diffusion voneinander getrennt wurden. Die Trennung erfolgte selbstjustierend entlang der Maskenkante. In der zu strukturierenden Schicht entsteht eine Lücke 11a.

Figur 9 zeigt einen Querschnitt der Anordnung nach einem selektiven Ätzprozeß, wodurch Teile der Schicht 13a aus der Maskenstruktur 13 entfernt wurden.

Figur 10 zeigt eine zu Figur 9 gehörige Aufsicht auf die Schicht 13a mit einer an einer Seite aufgebrachten Schutzschicht 14. Hierdurch wird an dieser Stelle das Zurückätzen verhindert.

Figur 11 zeigt einen Querschnitt aus Figur 10 nach Bildung der zweiten Struktur durch eine spannungsabhängige Diffusion. Neben Draht 12c entsteht eine weitere Lücke 11b.

Figur 12 zeigt die zu Figur 11 gehörige Aufsicht nach Entfernen der Maskenschichten 13a-b. Durch die aufgebrachte Schutzschicht 14 ist an dieser Stelle der entstandene Draht 12c mit der Schicht 12a verbunden geblieben.

Figur 13 zeigt einen Querschnitt der Anordnung aus dem nicht von der Schutzschicht 14 bedeckten Bereich nach Entfernen der Maskenstruktur 13 und Ätzen des Substrates 11 in den Bereichen der Lücken 11a und 11b. Unter dem Draht 12c entsteht ein Substratsteg 11c.

Figur 14 zeigt den Querschnitt einer Grundstruktur eines vertikalen Doppel-Gate-Schottky-Drain MOSFETs, wie er mit dem erfindungsgemäßen Verfahren hergestellt werden kann.

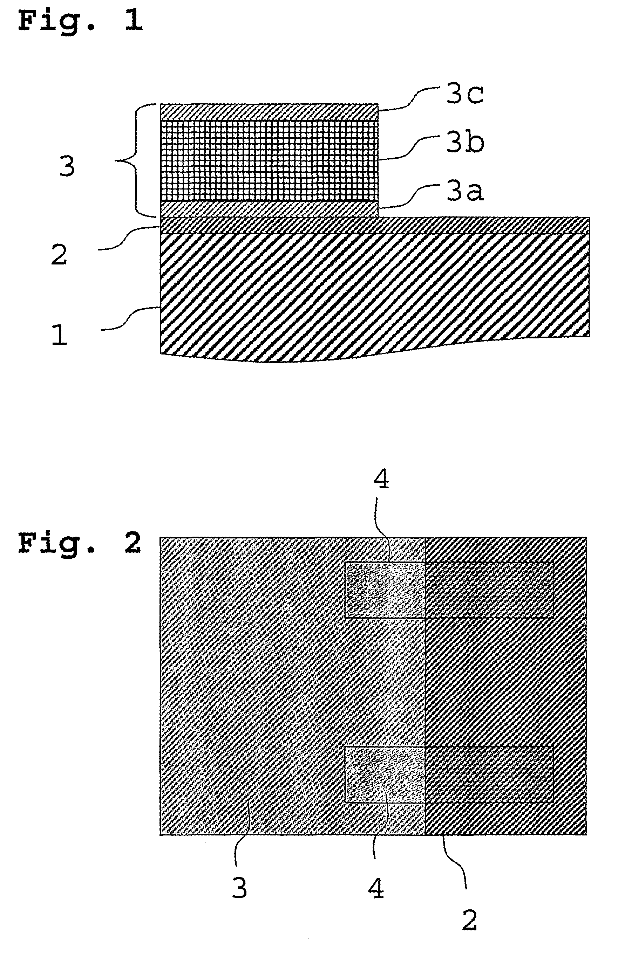

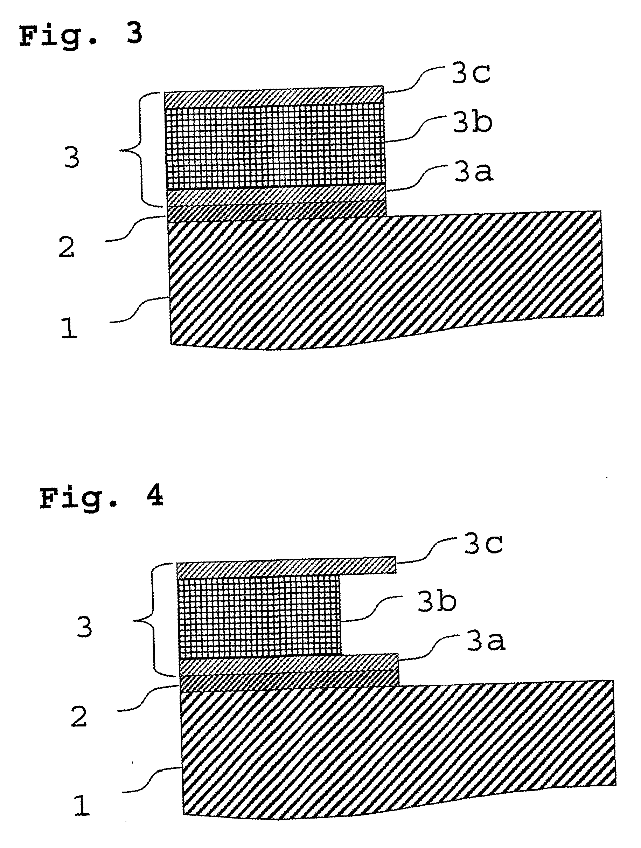

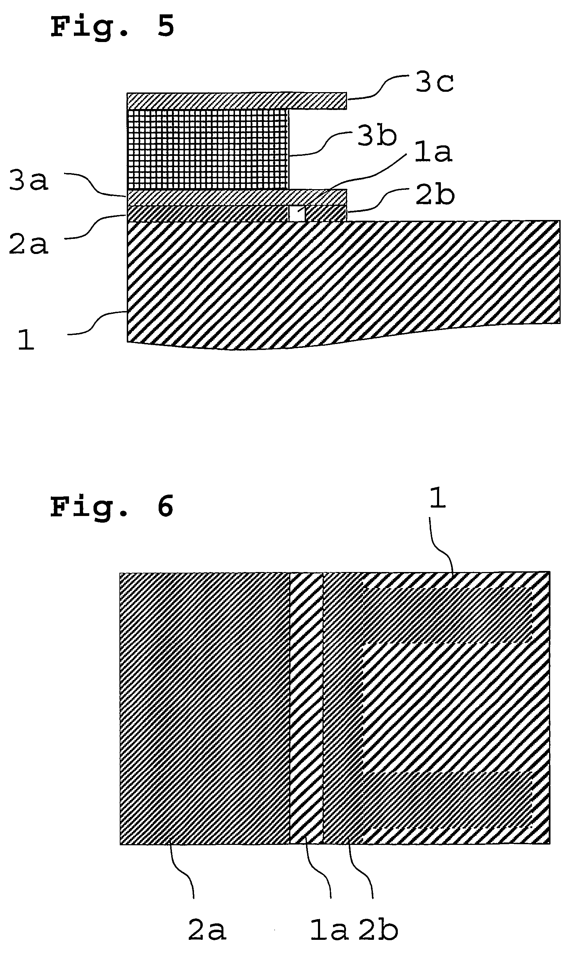

Gemäß eines ersten Ausführungsbeispiels wird eine 20-30 nm dicke Kobaltdisilizidschicht epitaktisch als zu strukturierende Schicht 2 auf ein Siliziumsubstrat 1 aufgebracht. Danach wird eine Maskenstruktur 3, bestehend aus einer 20 nm dicken SiO₂-Schicht 3a, einer 400 nm dicken Si₃N₄-Schicht 3b und wiederum einer weiteren 20 nm dicken SiO₂-Schicht 3c abgeschieden und mit Hilfe konventioneller optischer Lithographie strukturiert (Fig. 1). An den Kanten der so entstandenen Maskenstruktur 3 entsteht durch die intrinsische Spannung in der Nitridschicht 3b eine elastische Spannung in der darunter liegenden Schicht 3a sowie in der zu strukturierenden Schicht 2 und im Substrat 1. Nun werden zwei wiederum mit herkömmlicher optischer Lithographie strukturierte Photolackschutzschichten 4 aufgebracht (Fig. 2). Diese dienen zur Erzeugung von Kontakten zum später entstehenden Draht in der zu strukturierenden Schicht 2. Durch Plasmaätzen werden die Bereiche der zu strukturierenden Kobaltdisilizidschicht 2 entfernt, welche nicht von der Maskenstruktur 3 oder den Photolackschutzschichten 4 bedeckt sind (Fig. 3). Dann werden die Photolackschutzschichten 4 entfernt und durch Wachsen eines thermischen Oxides bei niedrigen Temperaturen kann das freiliegende Silizid sowie die Siliziumoberfläche vor dem folgenden Ätzschritt geschützt werden. Die Oxidationstemperatur wird gewöhnlich unter 800 °C, in jedem Fall aber so niedrig gewählt, daß eine Abtrennung der Kontaktbereiche von der Schicht durch lokale Oxidation nicht stattfindet. In dem nun folgenden Ätzschritt wird die Nitridschicht 3b mit einer Ätzlösung, z. B. mit einer Phosphorsäurelösung hoch selektiv zu dem dünnen Siliziumoxid kontrolliert lateral zurückgeätzt (Fig. 4). Damit verschiebt sich die von der Nitridschicht ausgeübte elastische Spannung in Richtung der Ätzung. Die Länge der Ätzung bestimmt die Breite des entstehenden Drahtes, wobei sie einige zehn Nanometer größer gewählt wird als der später entstehende Draht. Hieraus wird im weiteren Verlauf der Draht und eine entsprechende benachbarte Lücke gebildet. Die Deckschicht 3c verhindert bei diesem Schritt das Ätzen der Nitridschicht 3b in vertikaler Richtung. Im nächsten Schritt wird dann nach kurzem Spülen in Flußsäure zum Entfernen des Oxides die Struktur im Schnelltemperofen oxidiert, wobei sich auf Grund der anisotropen Diffusion in dem Spannungsfeld an den Kanten der zurückgeätzten Nitridschicht 3b die Silizidschicht 2 in eine Schicht 2a und in den abgetrennten Draht 2b auftrennt (Fig. 5). Die Aufsicht in Fig. 6 zeigt die entstandene Silizidstruktur nach Entfernen der Maskenstruktur 3. Der von der zu strukturierenden Schicht 2 abgetrennte Draht 2b ist von einer Lücke 1a benachbart. Der Draht weist eine Breite von 50 Nanometern auf und ist mit den vorher von den Schichten 4 abgedeckten Silizidbereichen verbunden.

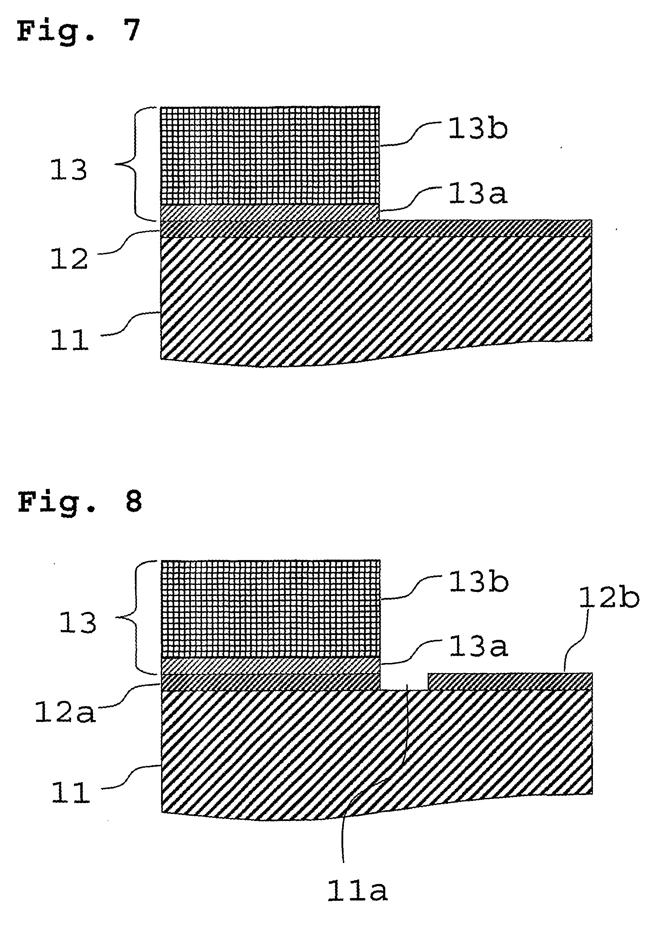

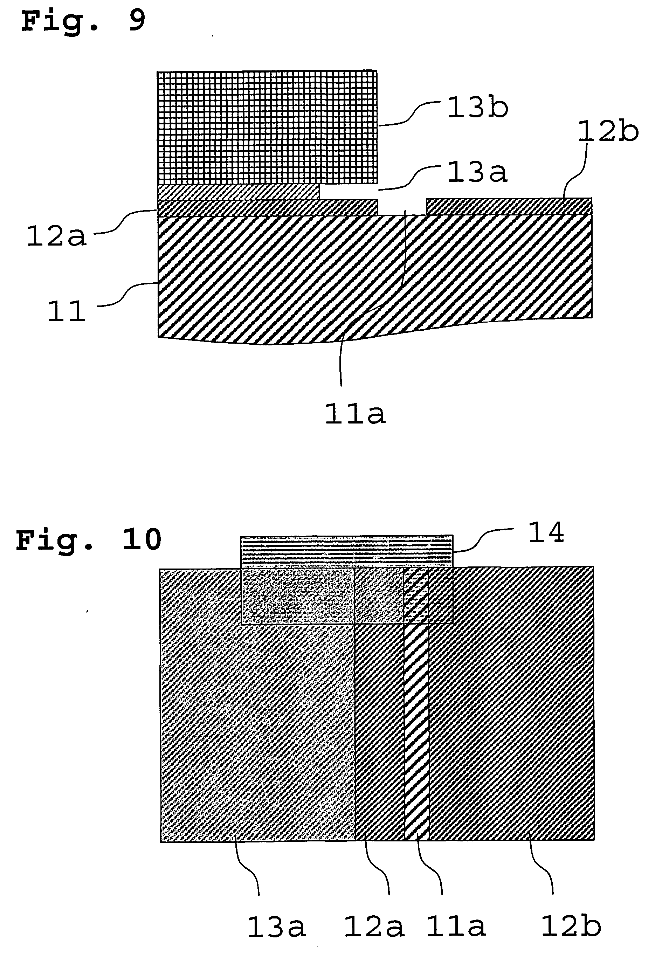

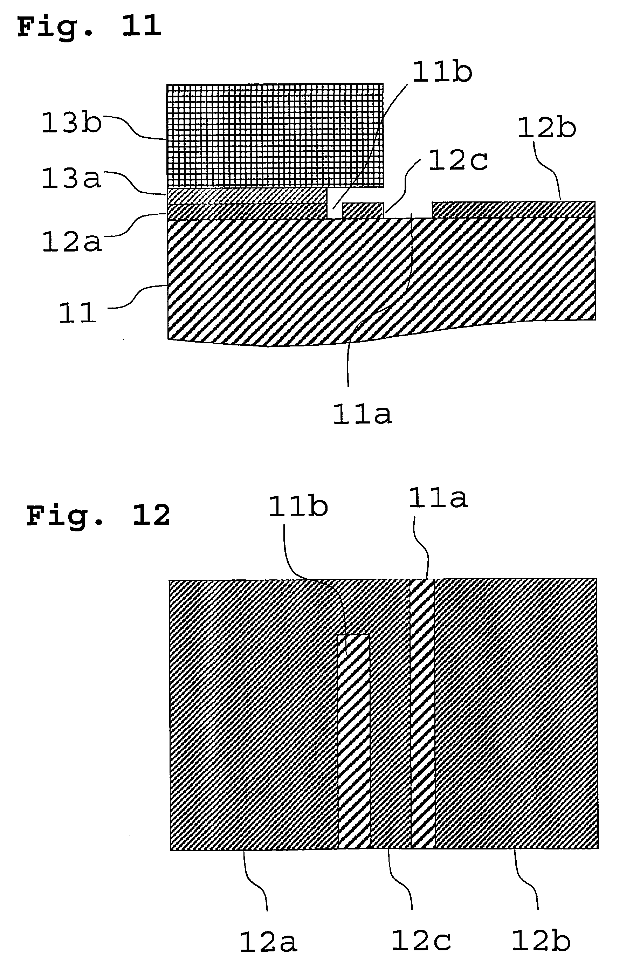

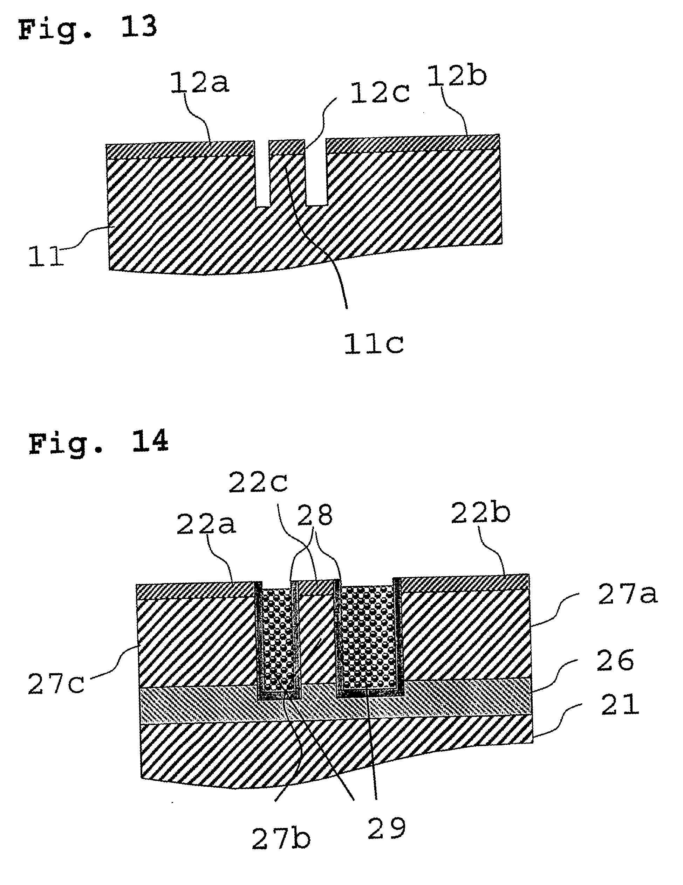

Gemäß eines zweiten Ausführungsbeispiels wird eine 20-30 nm dicke Kobaltdisilizidschicht 12 epitaktisch auf ein Siliziumsubstrat 11 aufgebracht. Danach wird eine Maskenstruktur 13, bestehend aus einer 20 nm dicken SiO₂-Schicht 13a und einer 400 nm dicken Si₃N₄-Schicht 13b abgeschieden und mit Hilfe konventioneller optischer Lithographie strukturiert (Fig. 7). Als Ergebnis entsteht eine Schichtenfolge aus einem Substrat 11, einer darauf aufliegenden, zu strukturierenden Schicht 12 sowie einer Maskenstruktur 13. An den Kanten der Maskenstruktur entsteht durch die intrinsische Spannung in der Nitridschicht 13b eine elastische Spannung in den darunter liegenden Schichten 13a, 12 und im Substrat 11. Durch Oxidation im Schnelltemperofen wird die Schicht 12 entlang der Maskenkante aufgetrennt, bedingt durch die anisotrope Diffusion der Kobaltatome während der Oxidation des Kobaltdisilizides (Fig. 8). Die Breite der Lücke 11a und damit der Abstand der beiden getrennten Schichten 12a und 12b beträgt 100 nm. Im nächsten Schritt wird dann die Oxidschicht 13a selektiv zur Nitridschicht 13b naßchemisch zurückgeätzt (Fig. 9), wobei die Länge der Ätzung der Breite des zu strukturierenden Drahtes entspricht (50-200 nm). Dabei wird an einer Seite eine SiO₂-Schutzschicht 14 aufgebracht, um diesen Teil der Maskenstruktur 13 vor dem Ätzen sowie der späteren Oxidation zu schützen (Fig. 10). Durch das Zurückätzen der SiO₂-Schicht 13a wird die elastische Spannung mit der Ätzung senkrecht zur ersten Strukturierung verschoben, da das Oxid 13a als Träger der spannungserzeugenden Nitridschicht 13b dient. Bei der folgenden Oxidation wird die zu strukturierende CoSi₂-Schicht entlang der neuen Oxidkante der Schicht 13a ein zweites Mal getrennt, so daß ein dünner Draht 12c entsteht (Fig. 11). Dieser Draht ist unter der Schutzschicht 14 mit der Schicht 12a verbunden. Fig. 12 zeigt eine Aufsicht der entstandenen CoSi₂-Struktur nach Entfernen der Maskenstruktur 13. Durch reaktives Ionenätzen in vertikaler Richtung, z. B. in einem Ar/SF₆-enthaltenden Plasma, kann mit Hilfe des Drahtes als Ätzmaske nun ein dünner Substratsteg 11c geätzt werden (Fig. 13).

Ein drittes Ausführungsbeispiel zeigt die Grundstruktur eines Doppel-Gate-Schottky-Drain MOSFETs, wie er in dem im zweiten Ausführungsbeispiel beschriebenen Strukturierungsverfahren hergestellt werden kann. Die Grundstruktur ist in Figur 14 dargestellt. Dabei wird zunächst eine hochdotierte Schicht 26 auf einem Siliziumsubstrat 21 erzeugt. Dies kann mittels Ionenimplantation oder Epitaxieverfahren geschehen. Daraufhin wird epitaktisch eine Siliziumschicht als Kanalschicht 27 und die zu strukturierende Kobaltdisilizidschicht 22 aufgebracht. Die Kanalschicht 27 kann dabei während der Epitaxie oder später durch Ionenimplantation moderat dotiert werden, so daß zwischen den Schichten 26 und der Kanalschicht 27 ein pn-Übergang entsteht und zwischen Kanalschicht 27 und zu strukturierender Schicht 22 ein Schottky-Kontakt. Danach wird die Schicht 22, wie im Ausführungsbeispiel 2, gemäß der Figuren 7-13 strukturiert und die Kanalschicht anschließend bis in die hochdotierte Schicht 26 geätzt. Der Siliziddraht 22c dient hierbei sowohl als Ätzmaske als auch als Schottky-Drain-Kontakt, der bereits mit einer Kontaktfläche verbunden ist. Nun wird ein Gateoxid 28 an den Seitenwänden des Siliziumsteges 27b erzeugt und ein Metall-Gate 29 angebracht. Dies stellt die Grundstruktur des MOSFETs dar. Die Kontaktierung von Gate und Source erfolgt durch Standardverfahren.

Alternativ kann an Stelle des Metall Gate 29 ein Polysilizium angebracht werden.

## Patentansprüche

1. Verfahren zur Herstellung von Strukturen im Nanometerbereich aus einer zu strukturierenden Schicht (2, 12) auf einem Substrat (1, 11), wobei eine Maskenstruktur (3, 13) auf der zu strukturierenden Schicht (2, 12) gebildet wird und die Maskenstruktur (3, 13) an ihren Kanten eine elastische Spannung in der zu strukturierenden Schicht (2, 12) und im Substrat (1, 11) erzeugt,
**gekennzeichnet durch** die Schritte:
- zur Festlegung einer ersten seitlichen Begrenzung der zu bildenden Struktur (2b, 12c) werden entweder maskierte Bereiche der zu strukturierenden Schicht (2, 12) von nicht maskierten Bereichen zur Bildung einer ersten Struktur (11a) voneinander getrennt oder nicht maskierte Bereiche **durch** Ätzung entfernt,
- eine elastische Spannung wird lateral zur Oberfläche der zu strukturierenden Schicht verschoben,
- Bereiche der zu strukturierenden Schicht (2, 12) werden **durch** eine spannungsabhängige Diffusion zur Festlegung einer zweiten seitlichen Begrenzung der zu bildenden Struktur (2b, 12c) voneinander getrennt.

2. Verfahren nach Anspruch 1,
**dadurch gekennzeichnet,**
**daß** die laterale Verschiebung der elastischen Spannung einen Ätzprozeß umfaßt.

3. Verfahren nach vorhergehendem Anspruch, **gekennzeichnet durch** einen naßchemischen Ätzprozeß.

4. Verfahren nach einem der vorhergehenden Ansprüche,
**dadurch gekennzeichnet,**
**daß** die spannungsabhängige Diffusion Tempern, eine lokale Oxidation und/oder eine spezifische Legierungsbildung umfaßt.

5. Verfahren nach einem der vorhergehenden Ansprüche,
**dadurch gekennzeichnet,**
**daß** die Bildung der ersten Struktur (11a) in der zu strukturierenden Schicht (2, 12) eine spannungsabhängige Diffusion umfaßt.

6. Verfahren nach einem der vorhergehenden Ansprüche, **gekennzeichnet durch** mindestens ein Metall, insbesondere Co, Ti, Ni, Pd, Pt, W, Ta oder Nb bzw. deren Silizide als Material zur Bildung der zu strukturierenden Schicht (2, 12).

7. Verfahren nach einem der vorhergehenden Ansprüche, **gekennzeichnet durch** CoSi₂ als Material für die zu strukturierende Schicht (2, 12).

8. Verfahren nach einem der vorhergehenden Ansprüche, **gekennzeichnet durch** SiO₂ und Si₃N₄ als Materialien zur Bildung der Maskenstruktur (3, 13).

9. Verfahren nach Anspruch 8, umfassend eine SiO₂-Si₃N₄-Schichtenfolge für die Maskenstruktur (13).

10. Verfahren nach Anspruch 8 oder 9,
**gekennzeichnet durch** das selektive Ätzen der SiO₂-Schicht (13a) in der Maskenstruktur (13).

11. Verfahren nach Anspruch 8, umfassend eine SiO₂-Si₃N₄-SiO₂-Schichtenfolge für die Maskenstruktur (3).

12. Verfahren nach Anspruch 11,
**gekennzeichnet durch** das selektive Ätzen der Si₃N₄-Schicht (3b) in der Maskenstruktur (3).

13. Verfahren nach einem der vorhergehenden Ansprüche, **gekennzeichnet durch** lokal angebrachte Schutzschichten (4, 14).

14. Verfahren nach Anspruch 13, bei dem Photolack oder SiO₂ als Schutzschicht (4, 14) verwendet wird.

15. Verfahren nach einem der Ansprüche 13 oder 14, bei dem durch lokal angebrachte Schutzschichten (4, 14) Drähte mit Kontaktflächen erzeugt werden.

16. Verfahren nach einem der vorhergehenden Ansprüche, **gekennzeichnet durch**
Entfernen der Maskenstruktur (3, 4; 13, 14) zur Freilegung der strukturierten Schicht (2a, 2b; 12a, 12b, 12c; 22a, 22b 22c).

17. Verfahren nach einem der vorhergehenden Ansprüche, bei dem durch die Strukturierung dünne Drähte (2b, 12c, 22c) erzeugt werden.

18. Verfahren nach Anspruch 17,
bei dem eine derart strukturierte Schicht (2, 12) mit Drähten (12c, 22c) als Maske zur Bildung einer Struktur im darunter liegenden Substrat (11; 27a, 27c) oder weiterer Schichten verwendet wird.

19. Verfahren nach Anspruch 18,
bei dem durch Ätzung, z.B. durch reaktives Ionenätzen in vertikaler Richtung ein dünner Substratsteg (11c, 27b) geätzt wird.

20. Verfahren nach einem der vorhergehenden Ansprüche, bei dem zur Herstellung der Grundstruktur eines Doppel-Gate-Schottky-Drain MOSFETs an den Seitenwänden eines Siliziumsteges (27b) ein Gateoxid (28) erzeugt und ein Metall-Gate (29) oder ein Polysilizium angebracht wird.

21. Schichtstruktur, hergestellt durch ein Verfahren nach einem der vorhergehenden Ansprüche, **gekennzeichnet durch** Drähte (2b, 12c, 22c) mit einer Breite von weniger als 130 nm.

22. Schichtstruktur nach vorhergehendem Anspruch, **gekennzeichnet durch** Drähte mit einer Breite von weniger als 50 nm.

23. Elektronisches Bauelement, umfassend eine Schichtstruktur nach einem der Ansprüche 21 oder 22.

24. Doppel-Gate-Schottky-Drain MOSFET, umfassend eine Schichtstruktur nach einem der Ansprüche 21 oder 22.

## Claims

1. Method for producing structures on a nanometric scale from a layer to be structured (2, 12) on a substrate (1, 11), in which a mask structure (3, 13) is formed on the layer to be structured (2, 12) and the mask structure (3, 13) at its edge produces an elastic stress in the layer to be structured (2, 12) and in the substrate (1, 11),
**characterised by** the steps:
- in order to set a first lateral boundary of the structure to be formed (2b, 12c) either masked areas of the layer to be structured (2, 12) are separated from unmasked areas to form a first structure (11a) or unmasked areas are removed by etching,
- an elastic stress is shifted laterally to the surface of the layer to be structured,
- areas of the layer to be structured (2, 12) are separated from each other by a stress-dependent diffusion in order to set a second lateral boundary of the structure to be formed (2b, 12c).

2. Method according to claim 1,
**characterised in that**
the lateral shifting of the elastic stress incorporates an etching process.

3. Method according to the preceding claim,
**characterised by** a wet chemical etching process.

4. Method according to one of the preceding claims,
**characterised in that**
the stress-dependent diffusion incorporates annealing, a local oxidation and / or a specific alloy formation.

5. Method according to one of the preceding claims,
**characterised in that**
the formation of the first structure (11a) in the layer to be structured (2, 12) encompasses a stress-dependent diffusion.

6. Method according to one of the preceding claims,
**characterised by** at least one metal, particularly Co, Ti, Ni, Pd, Pt, W, Ta or Nb or alternatively their silicides as being the material for forming the layer to be structured (2, 12).

7. Method according to one of the preceding claims,
**characterised by** CoSi₂ as the material for the layer to be structured (2, 12).

8. Method according to one of the preceding claims,
**characterised by** SiO₂ and Si₃N₄ as being the materials for forming the mask structure (3, 13).

9. Method according to claim 8, incorporating a SiO₂ - Si₃N₄ layer sequence for the mask structure (13).

10. Method according to claim 8 or 9,
**characterised by** the selective etching of the SiO₂ layer (13a) in the mask structure (13).

11. Method according to claim 8, incorporating a SiO₂ - Si₃N₄ - SiO₂ layer sequence for the mask structure (3).

12. Method according to claim 11,
**characterised by** the selective etching of the Si₃N₄ layer (3b) in the mask structure (3).

13. Method according to one of the preceding claims, **characterised by** locally applied protective layers (4, 14).

14. Method according to claim 13, in which photoresist or SiO₂ is used as the protective layer (4, 14).

15. Method according to one of claims 13 or 14, in which wires with contact surfaces are produced by locally applied protective layers (4, 14).

16. Method according to one of the preceding claims,
**characterised by**
removing the mask structure (3, 4; 13, 14) in order to expose the structured layer (2a, 2b; 12a, 12b, 12c; 22a, 22b, 22c).

17. Method according to one of the preceding claims, in which thin wires (2b, 12, 22c) are produced by the structuring.

18. Method according to claim 17,
in which a layer structured in this way (2, 12) with wires (12c, 22c) is used as a mask for forming a structure in the underlying substrate (11; 27a, 27c) or further layers.

19. Method according to claim 18,
in which a thin substrate web (11c, 27b) is etched by etching, e.g. by reactive ion etching in a vertical direction.

20. Method according to one of the preceding claims,
in which a gate oxide (28) is produced and a metal gate (29) or a polysilicon is applied in order to produce the basic structure of a double gate Schottky drain MOSFETs on the side walls of a silicon web (27b).

21. Layer structure produced by a method according to one of the preceding claims, **characterised by** wires (2b, 12c, 22c) with a width of less than 130 nm.

22. Layer structure according to the preceding claim, **characterised by** wires with a width of less than 50 nm.

23. Electronic component, incorporating a layer structure according to one of claims 21 or 22.

24. Double gate Schottky Drain MOSFET, incorporating a layer structure according to one of claims 21 or 22.

## Revendications

1. Procédé de préparation de structures de l'ordre du nanomètre à partir d'une couche à structurer (2, 12) sur un substrat (1, 11), dans lequel une structure de masque (3, 13) est formée sur la couche à structurer (2, 12) et la structure de masque (3, 13) produit à ses arêtes une tension élastique dans la couche à structurer (2, 12) et dans le substrat (1, 11),
**caractérisé par** les étapes :
- pour la définition d'une première limitation latérale de la structure à former (2b, 12c), soit des zones masquées de la couche à structurer (2, 12) sont séparées les unes des autres par des zones non masquées pour la formation d'une première structure (11a) soit des zones non masquées sont éliminées par attaque chimique,
- une tension élastique est décalée latéralement vers la surface de la couche à structurer,
- des zones de la couche à structurer (2, 12) sont séparées les unes des autres par une diffusion fonction de la tension pour la détermination d'une deuxième limitation latérale de la structure à former (2b, 12c).

2. Procédé selon la revendication 1,
**caractérisé en ce que**
le décalage latéral de la tension élastique comprend un processus d'attaque chimique.

3. Procédé selon la revendication précédente,
**caractérisé par** un processus d'attaque chimique par voie humide.

4. Procédé selon l'une des revendications précédentes,
**caractérisé en ce que**
la diffusion fonction de la tension comporte un traitement thermique, une oxydation locale et/ou la formation spécifique d'un alliage.

5. Procédé selon l'une des revendications précédentes,
**caractérisé en ce que**
la formation de la première structure (11a) dans la couche à structurer (2, 12) comporte une diffusion fonction de la tension.

6. Procédé selon l'une des revendications précédentes,
**caractérisé par** au moins un métal, en particulier du Co, du Ti, du Ni, du Pd, du Pt, du W, du Ta ou du Nb, respectivement leurs siliciures, comme matériau pour la formation de la couche à structurer (2, 12).

7. Procédé selon l'une des revendications précédentes,
**caractérisé par** C_{O}Si₂ comme matériau pour la couche à structurer (2, 12).

8. Procédé selon l'une des revendications précédentes,
**caractérisé par** SiO₂ et Si₃N₄ comme matériaux pour la formation de la structure de masque (3, 13).

9. Procédé selon la revendication 8, comprenant une suite de couches de SiO₂ et de Si₃N₄ pour la structure de masque (13).

10. Procédé selon la revendication 8 ou 9,
**caractérisé par** l'attaque chimique sélective de la couche de SiO₂ (13a) dans la structure de masque (13).

11. Procédé selon la revendication 8, comprenant une suite de couches SiO₂-Si₃N₄-SiO₂ pour la structure de masque (3).

12. Procédé selon la revendication 11,
**caractérisé par** l'attaque chimique sélective de la couche de Si₃N₄ (3b) dans la structure de masque (3).

13. Procédé selon l'une des revendications précédentes,
**caractérisé par** des couches de protection (4, 14) appliquées localement.

14. Procédé selon la revendication 13, dans lequel de la laque photo ou du SiO₂ sont utilisés comme couche de protection (4, 14).

15. Procédé selon l'une des revendications 13 ou 14, dans lequel, par des couches de protection (4, 14) appliquées localement, des fils avec des surfaces de contact sont engendrés.

16. Procédé selon l'une des revendications précédentes,
**caractérisé par**
l'enlèvement de la structure de masque (3, 4 ; 13, 14) pour dénuder la couche structurée (2a, 2b ; 12a, 12b, 12c ; 22a, 22b, 22c).

17. Procédé selon l'une des revendications précédentes,
dans lequel des fils minces (2b, 12c, 22c) sont engendrés par la structuration.

18. Procédé selon la revendication 17,
dans lequel une couche ainsi structurée (2, 12) avec des fils (12c, 22c) est utilisée comme masque pour la formation d'une structure dans le substrat (11 ; 27a, 27c) se trouvant en dessous, ou d'autres couches.

19. Procédé selon la revendication 18,
dans lequel, par attaque chimique, par exemple par attaque via une réaction ionique, une mince barrette de substrat (11c, 27b) est attaquée chimiquement dans la direction verticale.

20. Procédé selon l'une des revendications précédentes,
dans lequel, pour la préparation de la structure de base d'un MOSFET double grille et drain de Schottky, une grille oxyde (28) est engendrée sur les parois latérales d'une barrette de silicium (27b) et une grille de métal (29) ou un polysilicium est appliqué.

21. Structure en couches, préparée par un procédé selon l'une quelconque des revendications précédentes,
**caractérisée par** des fils (2b, 12c, 22c) d'une largeur de moins de 130 nm.

22. Structure en couches selon la revendication précédente, **caractérisée par** des fils d'une largeur de moins de 50 nm.

23. Composant électronique, comprenant une structure en couches selon l'une quelconque des revendications 21 ou 22.

24. MOSFET double grille et drain de Schottky, comprenant une structure en couches selon l'une quelconque des revendications 21 ou 22.
